# EUROPÄISCHE PATENTSCHRIFT

(11) **EP 2 725 373 B1**
(45) Veröffentlichungstag und Bekanntmachung des Hinweises auf die Patenterteilung: **03.04.2019**
(21) Anmeldenummer: 13188041.1
(22) Anmeldetag: 10.10.2013
(51) Int. Cl.: G01R 31/42, H02M 3/155

(54) **Elektrische Vorrichtung mit einem getakteten Netzteil und Verfahren zum Testen des Netzteils der elektrischen Vorrichtung**
Electrical device having a pulsed power supply and method for testing the power supply of said electrical device
Dispositif électrique doté d'une alimentation électrique pulsée et procédé de test de l'alimentation électrique de celui-ci

(30) Priorität: 23.10.2012 DE 102012219318
(43) Veröffentlichungstag der Anmeldung: 30.04.2014
(73) Patentinhaber: KUKA Deutschland GmbH, 86165 Augsburg (DE)
(72) Erfinder: Langhans, Michael, 86483 Balzhausen (DE); Zehetbauer, Sebastian, 81673 München (DE)
(74) Vertreter: Schlotter, Alexander Carolus Paul

(56) Entgegenhaltungen:
- US-A1- 2004 034 508
- US-A1- 2011 018 578

## Beschreibung

Die Erfindung betrifft eine elektrische Vorrichtung, insbesondere eine elektrische Maschine mit einem getakteten Netzteil und ein Verfahren zum Testen des Netzteils der elektrischen Vorrichtung.

Elektrische Vorrichtungen, beispielsweise elektrische Maschinen, umfassen bisweilen ein getaktetes Netzteil, welches ein Leistungsteil mit wenigstens einem Leistungshalbleiterschalter aufweist und das eingerichtet ist, aus einer elektrischen Spannung aufgrund eines abwechselnden Ein- und Ausschaltens des wenigstens einen Leistungshalbleiterschalters eine geregelte Spannung oder einen geregelten Strom für einen elektrischen Verbraucher zu erzeugen. Derartige Vorrichtungen werden beispielsweise in den Druckschriften US 2011/0018578 A1 und US 2004/0034508 A1 beschrieben.

Aufgabe der Erfindung ist es, eine Möglichkeit zu schaffen, die Funktionstüchtigkeit des Leistungshalbleiterschalters eines getakteten Netzteils im laufenden Betrieb der elektrischen Vorrichtung zu überprüfen.

Die Aufgabe der Erfindung wird gelöst durch eine elektrische Vorrichtung gemäß dem Anspruch 1. Eine elektrische Vorrichtung zum Erzeugen einer geregelten Spannung oder einen geregelten Strom kann aufweisen:
- einen elektrischen Verbraucher,
- ein getaktetes Netzteil, welches ein Leistungsteil mit wenigstens einem Leistungshalbleiterschalter aufweist und das eingerichtet ist, aus einer elektrischen Spannung aufgrund eines abwechselnden Ein- und Ausschaltens des wenigstens einen Leistungshalbleiterschalters eine elektrische Versorgungsspannung oder einen elektrischen Strom für den elektrischen Verbraucher zu erzeugen, wobei das Leistungsteil wenigstens einen Strompfad aufweist, durch den im Betrieb des Netzteils ein elektrischer Strom fließt,
- wenigstens einen Impulsübertrager, welcher eingerichtet ist, ein der Änderung des Betrags und/oder der Richtung des durch den Strompfand fließenden elektrischen Stroms zugeordnetes Signal zu erzeugen, und
- eine Auswertevorrichtung, welche eingerichtet ist, das vom Impulsübetrager stammende Signal auszuwerten und aufgrund des ausgewerteten Signals auf die Funktionstüchtigkeit des Leistungshalbleiterschalters zu schließen.

Die Aufgabe der Erfindung wird auch gelöst durch ein Verfahren gemäß dem Anspruch 10. Ein Verfahren zum Testen des Netzteils der erfindungsgemäßen elektrischen Vorrichtung, kann folgende Verfahrensschritte aufweisen:
- Abwechselndes Öffnen und Schließen des wenigstens einen Leistungshalbleiterschalters,
- Ermitteln eines Signals, welches der Änderung des Betrags und/oder der Richtung des elektrischen Stroms durch den Pfad des Leistungsteils des Netzteils zugeordnet ist mittels des Impulsübertrages, und
- Auswerten des mittels des Impulsübertragers erzeugten Signals und Schließen auf die Funktionstüchtigkeit des Leistungshalbleiterschalters aufgrund des ausgewerteten Signals.

Die erfindungsgemäße Vorrichtung ist beispielsweise eine elektrische Maschine, wie z.B. ein Roboter, und umfasst das getaktete Netzteil, welches vorgesehen ist, den elektrischen Verbraucher der erfindungsgemäßen Vorrichtung mit der elektrischen Versorgungsspannung bzw. dem elektrischen Strom zu versorgen. Die elektrische Versorgungsspannung ist insbesondere eine durch Taktung geregelte Spannung bzw. der elektrische Strom ist insbesondere ein durch Taktung geregelter elektrischer Strom. Der elektrische Verbraucher ist insbesondere ein induktiver Verbraucher, vorzugsweise eine elektromechanische Bremse. Elektromechanische Bremsen werden z.B. bei Robotern verwendet, um eines der Glieder dessen Roboterarms insbesondere in einer Notsituation zu bremsen. Roboter umfassen in der Regel einen Roboterarm und eine Steuervorrichtung. Der Roboterarm weist mehrere, hintereinander angeordnete und über Gelenke verbundene Glieder und elektrische Motoren zum Bewegen der Glieder relativ zueinander auf. Der induktiver Verbraucher kann beispielsweise auch ein Relais oder die Primärwicklung eines Leistungsübertrages bzw. einer Leistungsinduktivität für ein beliebiges Schaltnetzteil oder ein Motor in Verbindung mit einer mehrphasigen Brückenschaltung (Frequenzumrichter) sein.

Das getaktete Netzteil umfasst das Leistungsteil, welches den wenigstens einen Leistungshalbleiterschalter aufweist und eingerichtet ist, aus einer elektrischen Spannung aufgrund eines abwechselnden Ein- und Ausschaltens des wenigstens einen Leistungshalbleiterschalters die Versorgungsspannung bzw. den elektrischen für den elektrischen Verbraucher zu erzeugen. Das Leistungsteil ist beispielsweise als ein Wechselrichter ausgeführt. Der wenigstens eine Leistungshalbleiterschalter ist vorzugsweise als ein Leistungstransistor insbesondere als ein FET oder ein MOSFET ausgebildet.

Im Betrieb des Netzteils bzw. der erfindungsgemäßen elektrischen Vorrichtung wird der Leistungshalbleiterschalter abwechselnd geschlossen und geöffnet. Dazu umfasst das Netzteil z.B. eine geeignete Ansteuerelektronik, wie dies dem Fachmann im Prinzip bekannt ist.

Um im laufenden Betrieb der elektrischen Vorrichtung bzw. deren Netzteils die Funktionstüchtigkeit des Leistungshalbleiterschalters zu überprüfen, wird erfindungsgemäß die Änderung des elektrischen Stroms zumindest eines der Strompfade des Leistungsteils ausgewertet. Dazu umfasst die elektrische Vorrichtung erfindungsgemäß den wenigstens einen Impulsübertrager, dessen Ausgangssignal der Änderung dieses elektrischen Stroms bzw. dessen Betrags und/oder Richtung zugeordnet ist. Impulsübertrager als solche sind dem Fachmann im Prinzip bekannt und stellen im Wesentlichen Transformatoren bzw. Übertrager dar. Aufgrund des abwechselnden Ein- und Ausschaltens des Leistungshalbleiterschalters und bei Wahl eines geeigneten Strompfads des Leitungsteils ändert sich ständig der durch diesen Strompfad fließende elektrische Strom, solange der Leistungshalbleiterschalter in Ordnung ist. Eine Auswertung des Ausgangssignals des Impulsübertragers lässt somit einen Schluss über die Funktionstüchtigkeit des Leistungshalbleiterschalters zu. Die Verarbeitung des Ausgangssignals des Impulsübertragers und die davon abhängige Reaktion erfolgt z.B. mit Hilfe geeigneter digitaler Schaltungen, z.B. Mikrocontroller, DSPs oder FPGAs. Gegebenenfalls vorhandene Anforderungen aufgrund der Sicherheitsarchitektur, z.B. Zweikanaligkeit oder Redundanz, können beispielsweise erreicht werden durch geeignete Verschaltung der Treiberelemente für eine gegebenenfalls vorhandene Brückenschaltung, Rückmeldepfade von den Impulsübertragern, oder digitalen Steuerbauteile.

Nach einer bevorzugten Ausführungsform der erfindungsgemäßen elektrischen Vorrichtung ist der wenigstens eine Leistungshalbleiterschalter Teil des Strompfades. Somit wird im Wesentlichen die Änderung des Betrags und/ der Richtung des durch den Leistungshalbleiterschalter fließenden elektrischen Stroms ausgewertet.

Das Leistungsteil der erfindungsgemäßen elektrischen Vorrichtung ist vorzugsweise als H-Brücke ausgebildet. Diese umfasst insbesondere einen ersten Strompfad, durch den im Betrieb des Netzteils ein erster elektrischer Strom fließt, einen zweiten Strompfad, durch den im Betrieb des Netzteils ein zweiter elektrischer Strom fließt, einen dritten Strompfad, durch den im Betrieb des Netzteils ein dritter elektrischer Strom fließt, und einen vierten Strompfad, durch den im Betrieb des Netzteils ein vierter elektrischer Strom fließt, wobei der erste Strompfad und der vierte Strompfad mit einem gemeinsamen Knoten und der zweite Strompfad und der dritte Strompfad mit einem gemeinsamen Knoten verbunden sind, zwischen denen der elektrische Verbraucher geschaltet ist, wobei zumindest dem ersten, zweiten dritten und/oder vierten Strompfad ein Impulsübertrager zugeordnet ist, welcher eingerichtet ist, ein der Änderung des Betrags und/ der Richtung des durch den entsprechenden Strompfand fließenden elektrischen Stroms zugeordnetes Signal zu erzeugen, und die Auswertevorrichtung eingerichtet ist, das vom Impulsübetrager stammende Signal auszuwerten und aufgrund des ausgewerteten Signals auf die Funktionstüchtigkeit des Leistungshalbleiterschalters zu schließen.

Das als H-Brücke ausgebildete Leistungsteil kann z.B. derart ausgeführt sein, dass jeder der Strompfade wenigstens einen Leistungshalbleiterschalter umfasst. Die Leistungshalbleiterschalter sind vorzugsweise Transistoren, beispielsweise FETs oder MOSFETs.

Wenn es die Anwendung erlaubt, dann kann nach einer bevorzugten Ausführungsform der erfindungsgemäßen elektrischen Vorrichtung der erste Strompfad und der zweite Strompfad jeweils wenigstens einen Leistungshalbleiterschalter und der dritte Strompfad und der vierte Strompfad jeweils eine Diode umfassen. Somit kann mittels des getakteten Netzteils insbesondere eine getaktete Stromregelung für den elektrischen Verbraucher bzw. den induktiven Verbraucher realisiert werden. Das Aufmagnetisieren des induktiven Verbrauchers geschieht über Pfade mit den beiden Leistungshalbleiterschaltern. Das Abmagnetisieren des induktiven Verbrauchers erfolgt über die beiden Dioden.

Gemäß einer Ausführungsform der erfindungsgemäßen elektrische Vorrichtung ist jedem der Strompfade jeweils mindestens ein Impulsübertrager zugeordnet, welcher jeweils eingerichtet ist, ein der Änderung des Betrags und/ der Richtung des durch den entsprechenden Strompfand fließenden elektrischen Stroms zugeordnetes Signal zu erzeugen, und die Auswertevorrichtung eingerichtet ist, die von den Impulsübetrager stammenden Signale auszuwerten und aufgrund des ausgewerteten Signals auf die Funktionstüchtigkeit der Leistungshalbleiterschalter zu schließen. Dadurch kann die Funktionstüchtigkeit jedes einzelnen Leistungshalbleiterschalters überprüft werden.

Nach einer weiteren Variante der erfindungsgemäßen elektrischen Vorrichtung ist lediglich dem ersten und dem zweiten Strompfad wenigstens ein Impulsübertrager, oder lediglich dem dritten und dem vierten Strompfad wenigstens ein Impulsübertrager zugeordnet. Diese Variante bietet sich insbesondere dann an, wenn das Leistungsteil als H-Brücke ausgeführt ist und die Dioden umfasst. Je nach Anwendung kann es vorteilhaft sein, durch geeignete Polung des Impulsübertragers entweder die Stromänderung beim Schließen oder beim Öffnen des Leistungshalbleiterschalters auszuwerten. Dies kann entweder unmittelbar im Pfad mit dem Leistungshalbleiterschalter oder mittelbar im Pfad der Dioden bzw. Freilaufdiode erfolgen, wobei ein beginnender Freilaufstrom über ein erfolgreiches Trennen des Leistungshalbleiterschalters informiert.

Ein Ausführungsbeispiel der Erfindung ist exemplarisch in den beigefügten schematischen Zeichnungen dargestellt. Es zeigen:
- Fig. 1: einen Roboter mit einem Roboterarm,
- Fig. 2: teilweise einen Schaltplan eines getakteten Netzteils für eine Bremse des Roboterarms,
- Fig. 3: ein Schaltplan einer Auswerteelektronik und
- Fig. 4: Signal-, Spannungs- und Stromverläufe.

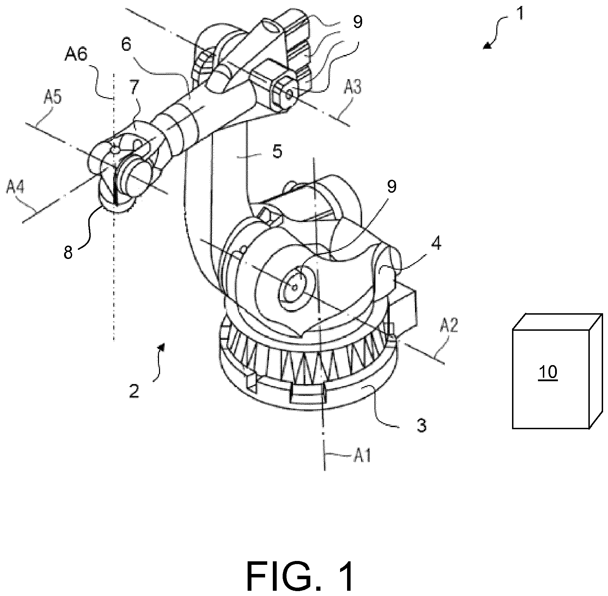

Die Fig. 1 zeigt einen Roboter 1 mit einem Roboterarm 2 in einer perspektivischen Darstellung.

Der Roboterarm 2 umfasst im Falle des vorliegenden Ausführungsbeispiels mehrere, nacheinander angeordnete und mittels Gelenke verbundene Glieder. Bei den Gliedern handelt es sich insbesondere um ein ortsfestes oder bewegliches Gestell 3 und ein relativ zum Gestell 3 um eine vertikal verlaufende Achse A1 drehbar gelagertes Karussell 4. Weitere Glieder des Roboterarms 2 sind im Falle des vorliegenden Ausführungsbeispiels eine Schwinge 5, ein Ausleger 6 und eine vorzugsweise mehrachsige Roboterhand 7 mit einer z.B. als Flansch 8 ausgeführten Befestigungsvorrichtung zum Befestigen eines nicht näher dargestellten Endeffektors. Die Schwinge 5 ist am unteren Ende z.B. an einem nicht näher dargestellten Schwingenlagerkopf auf dem Karussell 4 um eine vorzugsweise horizontale Achse A2 schwenkbar gelagert. Am oberen Ende der Schwinge 5 ist wiederum um eine ebenfalls vorzugsweise horizontale Achse A3 der Ausleger 6 schwenkbar gelagert. Dieser trägt endseitig die Roboterhand 7 mit ihren vorzugsweise drei Achsen A4, A5, A6.

Um den Roboter 1 bzw. dessen Roboterarm 2 zu bewegen, umfasst dieser in allgemein bekannter Weise mit einer Steuervorrichtung 10 verbundene elektrische Antriebe. In der Figur 1 sind nur einige der elektrischen Motoren 9 dieser elektrischen Antriebe gezeigt, welche im oder am Roboterarm 2 befestigt sind. Leistungselektroniken der elektrischen Antriebe sind z.B. innerhalb eines Gehäuses eines nicht näher dargestellten Steuerschranks angeordnet, innerhalb dem z.B. auch die Steuervorrichtung 10 angeordnet ist. Die elektrischen Motoren 9 sind im Falle des vorliegenden Ausführungsbeispiels Drehstrommotoren, beispielsweise Drehstrom-Synchronmotoren. Die Leistungselektroniken können aber auch im und/oder am Roboterarm 2 angeordnet sein.

Die Leistungselektroniken umfassen im Falle des vorliegenden Ausführungsbeispiels, wie dies dem Fachmann im Prinzip bekannt ist, einen nicht näher dargestellten Gleichrichter, welcher aus der Netzspannung eine Gleichspannung erzeugt, einen dem Gleichrichter nachgeschalteten, ebenfalls nicht näher dargestellten Zwischenkreis mit einem Zwischenkreiskondensator zum Glätten der Gleichspannung und mehrere, dem Zwischenkreiskondensator nachgeschaltete Umrichter bzw. Wechselrichter.

Auf der Steuervorrichtung 10, welche z.B. als ein Computer ausgeführt ist, läuft ein Rechenprogramm, mittels dem die Steuervorrichtung 10 im Betrieb des Roboters 1 diesen beispielsweise derart ansteuert, dass der Flansch 8 oder ein sogenannter Tool Center Point eine vorbestimmte Bewegung ausführt. Gegebenenfalls regelt die Steuervorrichtung 10 die elektrischen Antriebe, wie dies im Prinzip dem Fachmann bekannt ist. Gegebenenfalls sind die elektrischen Antriebe geregelte elektrische Antriebe und die Steuervorrichtung 10 erzeugt Soll-Signale für die geregelten elektrischen Antriebe bzw. deren Wechselrichter.

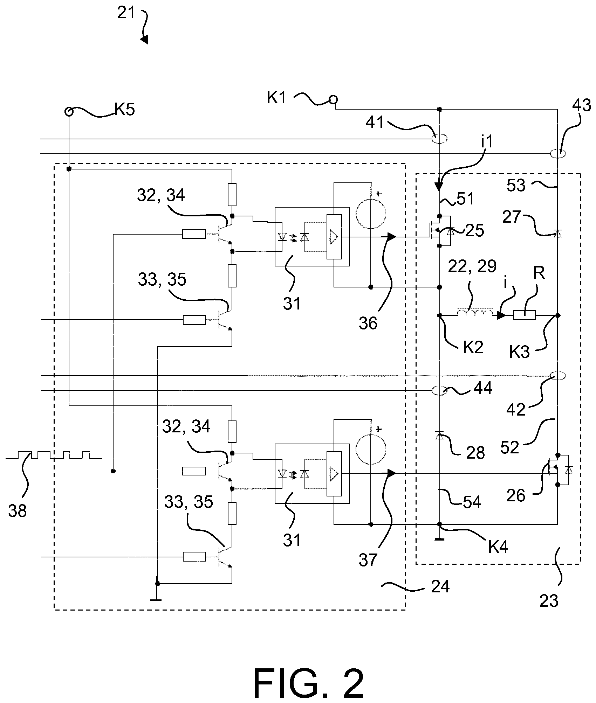

Im Falle des vorliegenden Ausführungsbeispiels umfasst der Roboter 1 elektromechanische Bremsen zum Bremsen der einzelnen Glieder. Die Bremsen sind derart ausgeführt, dass sie im gelösten Zustand mittels einer mit einem elektrischen Strom beaufschlagten Induktivität gehalten werden. Wird die Induktivität abgeschaltet, dann löst die Bremse automatisch aus und bremst das ihr zugeordnete Glied des Roboterarms 2. Dazu umfassen die Bremsen beispielsweise vorgespannte Federn. Die Fig. 2 zeigt beispielsweise die Induktivität 22 der zum Bremsen des Karussells 4 vorgesehnen Bremse.

Um im Betrieb des Roboters 1 die Bremse in ihrem gelösten Zustand zu halten bzw. von ihrem ausgelösten in ihren gelösten Zustand zu bringen, umfasst der Roboter 1 im Falle des vorliegenden Ausführungsbeispiels den Bremsen zugeordnete getaktete Netzteile. In der Fig. 2 ist das der Bremse des Karussells 4 zugeordnete getaktete Netzteil 21 gezeigt. Die Induktivität 22 stellt somit einen elektrischen Verbraucher, insbesondere einen induktiven Verbraucher 29 für das Netzteil 21 dar.

Das Netzteil 21 umfasst im Falle des vorliegenden Ausführungsbeispiels ein Leistungsteil 23 und eine Ansteuerelektronik 24, die eingerichtet ist, das Leitungsteil 23 anzusteuern.

Im Falle des vorliegenden Ausführungsbeispiels ist das Leistungsteil 23 als H-Brücke aufgebaut und umfasst mehrere elektrische Pfade, durch die im Betrieb des Netzteils 21 elektrische Ströme fließen. Es umfasst im Falle des vorliegenden Ausführungsbeispiels einen ersten Leistungshalbleiterschalter 25, einen zweiten Leistungshalbleiterschalter 26, eine erste Diode 27 und eine zweiten Diode 28. Die beiden Leistungshalbleiterschalter 25, 26 sind beispielsweise Leistungstransistoren, die vorzugsweise in FET Technologie ausgeführt sind. Als Leistungshalbleiterschalter können aber auch andere Bauteile z.B. Leistungstransistoren in bipolarer Technologie verwendet werden.

Das Leistungsteil 23 bzw. die H-Brücke wird z.B. von einer ersten Versorgungsspannung versorgt, die insbesondere eine elektrische Gleichspannung ist und an einem ersten Knoten K1 anliegt. Diese wird z.B. aus der Netzspannung mittels Gleichrichtung und anschließender Glättung erzeugt.

Im Falle des vorliegenden Ausführungsbeispiels ist die Topologie des als H-Brücke aufgebauten Leistungsteils 23 wie folgt:
Der erste Leistungshalbleiterschalter 25 ist einerseits mit dem ersten Knoten K1 und andererseits mit einem zweiten Knoten K2 verbunden und ist Teil eines ersten Strompfads 51, durch den im Betrieb des Netzteils 21 ein elektrischer Strom i1 fließt. Die erste Diode 27 ist einerseits mit dem ersten Knoten K1 und einem dritten Knoten K3 insbesondere in Sperrrichtung verbunden und ist Teil eines dritten Strompfads 53. Zwischen dem zweiten Knoten K2 und dem dritten Knoten K3 ist die Induktivität 22 der Bremse geschaltet. In der Fig. 2 ist in Serie zur Induktivität 22 der Bremse auch noch ein Innenwiderstand R dargestellt.

Der zweite Leistungshalbleiterschalter 26, der Teil eines zweiten Strompfads 52 ist, ist einerseits mit dem dritten Knoten K3 und andererseits mit einem vierten Knoten K4 verbunden, der im Falle des vorliegenden Ausführungsbeispiels mit Masse verbunden ist. Die zweite Diode 28, die Teil eines vierten Strompfads 54 ist, ist einerseits mit dem zweiten Knoten K2 und dem vierten Knoten K4 insbesondere in Sperrrichtung verbunden. Anstelle der beiden Dioden 27, 28 können aber auch weitere Leistungshalbleiterschalter, ähnlich der beiden Leistungshalbleiterschalter 25, 26, verwendet werden.

Im Falle des vorliegenden Ausführungsbeispiels werden im Normalbetrieb, d.h. in einem Betrieb, in dem die Bremse gelöst ist und somit ihr relevantes Glied nicht bremst, die beiden Leistungshalbleiterschalter 25, 26 abwechselnd ein und ausgeschaltet. Insbesondere werden diese mittels pulsweitenmodulierter Signale ein und ausgeschaltet. Im Falle des vorliegenden Ausführungsbeispiels ist es vorgesehen, die Bremsen in ihrem gelösten Zustand mittels des Netzteils 21 mit einem geringeren elektrischen Strom (Haltestrom) zu beaufschlagen als mit einem elektrischen Strom, um die Bremse von ihrem ausgelösten, bremsenden Zustand, in ihren gelösten, nicht-bremsenden Zustand zu bringen. Dadurch werden die beiden Leistungshalbleiterschalter 25, 26 in geeigneter Weise mittels der Ansteuerelektronik 24, welche die pulsweitenmodulierten Signale erzeugen, ein und ausgeschaltet.

Im Falle des vorliegenden Ausführungsbeispiels umfasst die Ansteuerelektronik 24 zwei Optokoppler 31, zwei erste Halbleiterschalter 32 und zwei zweite Halbleiterschalter 33. Die Halbleiterschalter 32, 33 sind insbesondere als erste Transistoren 34 und als zweite Transistoren 35 ausgeführt. Diese Transistoren 34, 35 sind beispielsweise bipolare Transistoren.

Die Optokoppler 31 umfassen im Falle des vorliegenden Ausführungsbeispiels jeweils eine als einen Lichtsender ausgeführte Eingangsstufe, welche Licht emittiert, wenn am Eingang des entsprechenden Optokoplers 31 eine elektrische Spannung anliegt. Die Lichtsender sind insbesondere als Leuchtdioden ausgeführt. Als Ausgangsstufen umfasst jeder der Optokoppler 31 einen Lichtempfänger, welcher das von dem entsprechenden Lichtsender emittierte Licht in ein elektrisches Signal umwandelt, welches als erstes pulsweitenmoduliertes Signal 36 für den ersten Leistungshalbleiterschalter 25 bzw. als zweites pulsweitenmoduliertes Signal 37 für den zweiten Leistungshalbleiterschalter 25 dient. Im Falle des vorliegenden Ausführungsbeispiels weisen die Ausgangsstufen bzw. die Lichtempfänger der Optokoppler 31 jeweils eine mit dem entsprechenden Lichtsender gekoppelte Fotodiode und eine der Fotodiode nachgeschaltete Treiberstufe auf. Der Ausgang einer der Treiberstufen ist mit dem Gate des ersten Leistungshalbleiterschalters 25 und der Ausgang der anderen Treiberstufen ist mit dem Gate des zweiten Leistungshalbleiterschalters 26 verbunden, wenn es sich bei diesen um FET-Transistoren handelt.

Im Falle des vorliegenden Ausführungsbeispiels sind jeweils ein erster Halbleiterschalter 32 derart parallel zur Eingangsstufe einer der Optokoppler 31 geschaltet, dass bei geschlossenem ersten Halbleiterschalter 32 der Eingang des entsprechenden Optokopplers 31 bzw. dessen Lichtsender elektrisch kurzgeschlossen ist. Wenn es sich bei dem ersten Halbleiterschalter 32 um einen bipolaren ersten Transistor 34 handelt, dann sind insbesondere der Kollektor und der Emitter dieses ersten Transistors 34 mit dem Lichtsender des entsprechenden Optokopplers 31 verbunden und der erste Transistor 34 wird durch Ansteuern seiner Basis ein bzw. ausgeschaltet.

Im Falle des vorliegenden Ausführungsbeispiels ist jeweils einer der zweiten Halbleiterschalter 33 der Ansteuerelektronik 24 in Serie zu einer der Parallelschaltungen aus einem der Optokoppler 31 und einem der ersten Halbleiterschalter 32 geschaltet.

Im Betrieb des Roboters 2 wird die Ansteuerelektronik 24 mit einer zweiten Versorgungsspannung versorgt, welche an einem fünften Knoten K5 anliegt. Mittels der zweiten Versorgungsspannung werden die Serienschaltungen, jeweils aufweisend einen der zweiten Halbleiterschalter 33 und der Parallelschaltungen aus einem der Optokoppler 31 und einem der ersten Halbleiterschalter 32 mit elektrischer Energie versorgt.

Im Normalbetrieb sind die zweiten Halbleiterschalter 33 geschlossen bzw. sind die zweiten Transistoren 34 leitend und die ersten Halbleiterschalter 32 werden mittels Pulsweitenmodulation geöffnet und geschlossen, sodass die beiden Leistungshalbleiterschalter 25, 26 entsprechend der gewählten Pulsweitenmodulation angesteuert werden.

Über die an den Basen der ersten Transistoren 34 anliegenden Pulsmuster 38 der Pulsweitenmodulation steuern die Optokoppler 31 die beiden Leistungshalbleiterschalter 25, 26 an. Im Falle des vorliegenden Ausführungsbeispiels repräsentieren die Pulsmuster 38 an den Basen der ersten Transistoren 32 das invertierte Pulsmuster für die Ausgangsstufen der Optokoppler 31 (pulsmodulierte Signale 36, 37 der Optokoppler 31), da bei geöffneten ersten Halbleiterschaltern 32 an dem Lichtsender des entsprechenden Optokopplers 31 die zweite Versorgungsspannung anliegt und somit die Optokoppler 31 bei geöffneten ersten Halbleiterschaltern 32 die beiden Leistungshalbleiterschalter 25, 26 einschalten. Ist dagegen der entsprechende erste Halbleiterschalter 32 geschlossen, dann wird der Lichtsender des entsprechenden Optokopplers 31 kurz geschlossen und deaktiviert dadurch den jeweiligen Leistungshalbleiterschalter 26, 28.

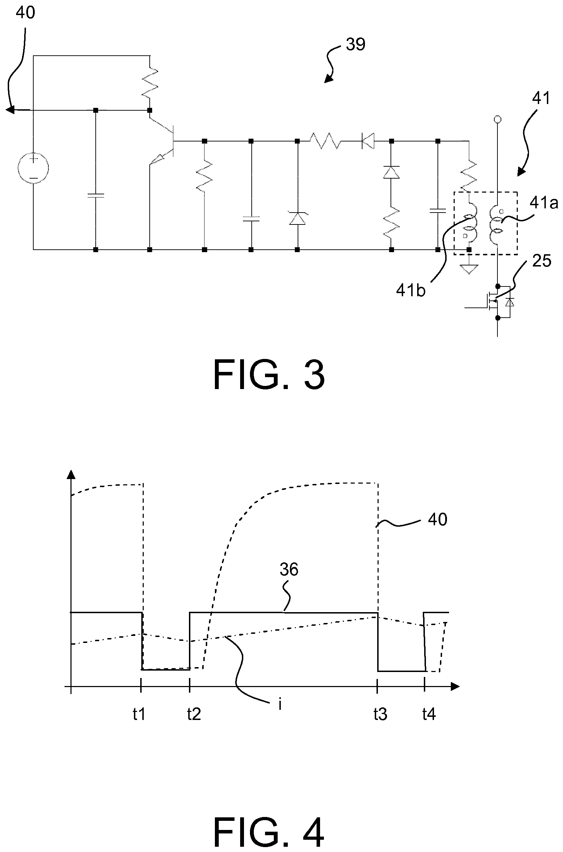

Die Fig. 4 zeigt den Verlauf des ersten pulsmodulierten Signals 36 für den ersten Leistungshalbleiterschalter 25. Zum Zeitpunkt t1 schaltet dieses von logisch "1" auf logisch "0" und schaltet somit den ersten Leistungshalbleiterschalter 25 aus. Zum Zeitpunkt t2 schaltet dieses von logisch "0" auf logisch "1" und schaltet somit den ersten Leistungshalbleiterschalter 25 wieder ein. Zum Zeitpunkt t3 schaltet dieses von logisch "1" auf logisch "0" und schaltet somit den ersten Leistungshalbleiterschalter 25 wieder aus und zum Zeitpunkt t4 schaltet dieses von logisch "0" auf logisch "1" und schaltet somit den ersten Leistungshalbleiterschalter 25 ein. Dadurch fließt durch den induktiven Verbraucher 29 ein elektrischer Strom i, dessen Verlauf in der Fig. 4 gezeigt ist.

Die zweiten Halbleiterschalter 33 sind im Falle des vorliegenden Ausführungsbeispiels vorgesehen, beispielsweise in einer Notsituation die Bremse automatisch zu schließen, indem sie die Versorgung der Optokoppler 31 mit elektrischer Energie unterbrechen.

Somit wird mittels des getakteten Netzteils 21 insbesondere eine getaktete Stromregelung für den induktiven Verbraucher 29 realisiert. Das Aufmagnetisieren des induktiven Verbrauchers 29 geschieht über den ersten und zweiten Pfad 51, 52 mit den beiden Leistungshalbleiterschaltern 25, 26. Das Abmagnetisieren des induktiven Verbrauchers 29 erfolgt im Falle des vorliegenden Ausführungsbeispiels über die beiden Dioden 27, 28 oder mit Hilfen weiterer Leistungshalbleiterschalter.

Wie bereits beschrieben, löst die Bremse aus, wenn durch ihre Induktivität 22 dauerhaft kein elektrischer Strom i mehr fließt. Dies wird erreicht, indem die beiden Leistungshalbleiterschalter 25, 26 dauerhaft nicht leitend werden.

Um die Funktionstüchtigkeit der beiden Leistungshalbleiterschalter 25, 26 auch im laufenden Betrieb bzw. Normalbetrieb des Roboters 1 zu überprüfen, d.h. um die Funktionstüchtigkeit der beiden Leistungshalbleiterschalter 25, 26 auch bei gelöster Bremse zu überprüfen, umfasst der Roboter 1 im Falle des vorliegenden Ausführungsbeispiels einen ersten Impulsübertrager 41, einen zweiten Impulsübertrager 42, einen dritten Impulsübertrager 43 und einen vierten Impulsübertrager 44.

Der erste Impulsübertrager 41 ist vorgesehen, ein Signal entsprechend der Änderung des Betrags und/oder der Richtung des elektrischen Stroms i1 des ersten Pfandes 51 zu erzeugen. Der elektrische Strom i1 des ersten Pfades 51 fließt durch den ersten Leistungshalbleiterschalter 25. Der erste Impulsübertrager 41 ist beispielsweise zwischen dem ersten Leistungshalbleiterschalter 25 und dem ersten Knoten K1 geschaltet.

Der zweite Impulsübertrager 42 ist vorgesehen, ein Signal entsprechend der Änderung des Betrags und/oder der Richtung des elektrischen Stroms durch die zweiten Leistungshalbleiterschalter 26 bzw. des elektrischen Stroms des zweiten Pfades 52 zu erzeugen. Der zweite Impulsübertrager 42 ist beispielsweise zwischen dem zweiten Leistungshalbleiterschalter 26 und dem dritten Knoten K3 geschaltet.

Der dritte Impulsübertrager 43 ist vorgesehen, ein Signal entsprechend der Änderung des Betrags und/oder der Richtung des elektrischen Stroms durch die erste Diode 27 bzw. des elektrischen Stroms des dritten Pfades 53 zu erzeugen. Der dritte Impulsübertrager 43 ist beispielsweise zwischen der ersten Diode 27 und dem ersten Knoten K1 geschaltet.

Der vierte Impulsübertrager 44 ist vorgesehen, ein Signal entsprechend der Änderung des Betrags und/oder der Richtung des elektrischen Stroms durch die zweite Diode 28 bzw. des elektrischen Stroms des vierten Pfades 54 zu erzeugen. Der vierte Impulsübertrager 44 ist beispielsweise zwischen der zweiten Diode 28 und dem zweiten Knoten K2 geschaltet.

Mittels der Impulsübertrager 41-44, welche insbesondere im Wesentlichen induktive Koppler zwischen den Ästen bzw. Pfaden der H-Brücke darstellen, kann somit eine Rückmeldung über die Kommutiervorgänge in der H-Brücke erfolgen.

Abweichend von der beispielhaften Darstellung können auch weniger als vier Impulsübertrager vorhanden sein, um vollständige Informationen über die Abschaltfähigkeit der Leistungshalbleiterschalter zu gewinnen.

Im Falle des vorliegenden Ausführungsbeispiels umfasst der Roboter 2 den Impulsübertragern 41-44 nachgeschaltete Auswerteschaltungen, von denen die Auswerteschaltung 39 für den ersten Impulsübertrager 41 in der Fig. 3 gezeigt ist. Impulsübertrager 41 sind im Wesentlichen Übertrager bzw. Transformatoren und weisen wenigstens eine Primärwicklung und wenigstens eine Sekundärwicklung auf. In der Fig. 3 ist die wenigstens eine Primärwicklung mit dem Bezugszeichen 41a und die wenigstens eine Sekundärwicklung mit dem Bezugszeichen 41b gekennzeichnet. Das Ausgangssignal 40 der Auswerteschaltung 39 sowie die Ausgangssignale der restlichen Auswerteschaltungen werden im Falle des vorliegenden Ausführungsbeispiels der Steuervorrichtung 10 übertragen, auf der insbesondere ein Rechenprogramm läuft, welche die Ausgangssignale 40 der Auswerteschaltung 39, welche eine Information über die Änderungen der Beträge und/oder Richtungen der elektrischen Ströme der elektrischen Pfade 51-54 umfassen, auswerten, um einen schadhaften Leistungshalbleiterschalter 25, 26 zu erkennen.

Aufgrund des abwechselnden Ein und Ausschaltens der beiden Leistungshalbleiterschalter 25, 26 gemäß den pulsmodulierten Signalen 36, 37 ändert sich bei jedem Umschalten der elektrische Strom i durch die Induktivität 22 bzw. die durch die beiden Leistungshalbleiterschalter 25, 26 und den beiden Dioden 27, 28 fließenden elektrischen Ströme und somit auch die Ausgangssignale der Impulsübertrager 41-44. Die Fig. 4 zeigt den Verlauf des Ausgangssignals 40 der dem ersten Impulsübertrager 41 zugeordneten Auswerteschaltung 39, welches sich entsprechend dem Pulsmuster der Pulsweitenmodulation ändert, solange der erste Leistungshalbleiterschalter 25 in Ordnung ist.

## Patentansprüche

1. Elektrische Vorrichtung, insbesondere elektrische Maschine, aufweisend
- einen elektrischen Verbraucher (29),
- eine Steuervorrichtung (10), welche ein pulsweitenmoduliertes Signal erzeugt,
- ein getaktetes Netzteil (21), welches ein Leistungsteil (23) mit wenigstens einem Leistungshalbleiterschalter (25, 26) aufweist und das eingerichtet ist, aus einer elektrischen Spannung aufgrund eines dem pulsweitenmodulierten Signal entsprechenden abwechselnden Ein- und Ausschaltens des wenigstens einen Leistungshalbleiterschalters (25, 26) eine elektrische Versorgungspannung oder einen elektrischen Strom für den elektrischen Verbraucher (29) zu erzeugen, wobei das Leistungsteil (23) wenigstens einen Strompfad (51-54) aufweist, durch den im Betrieb des Netzteils (21) ein elektrischer Strom (i1) fließt,
- wenigstens einen Impulsübertrager (41-44), welcher eingerichtet ist, ein der Änderung des Betrags und/oder der Richtung des durch den Strompfad (51) fließenden elektrischen Stroms (i1) entsprechendes Ausgangssignal zu erzeugen, und
- eine dem Impulsübertrager nachgeschaltete Auswerteschaltung (39), welche eingerichtet ist, das Ausgangssignal auf die Steuervorrichtung (10) zu übertragen, und
- die Steuervorrichtung (10) eingerichtet ist, auf die Funktionstüchtigkeit des Leistungshalbleiterschalters (25, 26) zu schließen, wenn das Ausgangssignal sich entsprechend dem pulsweitenmodulierten Signal ändert.

2. Elektrische Vorrichtung nach Anspruch 1, bei der das Leistungsteil (23) als ein Wechselrichter und/oder bei der der wenigstens eine Leistungshalbleiterschalter (25,26) als ein Leistungstransistor insbesondere als ein FET oder ein MOSFET ausgebildet ist, und/oder bei der der elektrische Verbraucher als ein elektrischer induktiver Verbraucher (29) ausgeführt ist.

3. Elektrische Vorrichtung nach Anspruch 2, bei der der induktive Verbraucher (29) als eine elektromechanische Bremse ausgeführt ist.

4. Elektrische Vorrichtung nach einem der Ansprüche 1 bis 3, bei der der wenigstens eine Leistungshalbleiterschalter (25, 26) Teil des Strompfades (51, 52) ist.

5. Elektrische Vorrichtung nach einem der Ansprüche 1 bis 4, deren Leistungsteil (23) als H-Brücke ausgebildet ist, welche insbesondere einen ersten Strompfad (51), durch den im Betrieb des Netzteils (21) ein erster elektrischer Strom (i1) fließt, einen zweiten Strompfad (52), durch den im Betrieb des Netzteils (21) ein zweiter elektrischer Strom fließt, einen dritten Strompfad (53), durch den im Betrieb des Netzteils (21) ein dritter elektrischer Strom fließt, und einen vierten Strompfad (54), durch den im Betrieb des Netzteils (21) ein vierter elektrischer Strom fließt, aufweist, wobei der erste Strompfad (51) und der vierte Strompfad (54) mit einem gemeinsamen ersten Knoten (K2) und der zweite Strompfad (52) und der dritte Strompfad (53) mit einem gemeinsamen zweiten Knoten (K3) verbunden sind, zwischen denen der elektrische Verbraucher (29) geschaltet ist, wobei zumindest dem ersten, zweiten dritten und/oder vierten Strompfad (51-54) ein Impulsübertrager (41-44) zugeordnet ist, welcher eingerichtet ist, ein der Änderung des Betrags und/oder der Richtung des durch den entsprechenden Strompfad (51) fließenden elektrischen Stroms (i1) entsprechendes Ausgangssignal zu erzeugen, und die Steuervorrichtung (10) eingerichtet ist, auf die Funktionstüchtigkeit des Leistungshalbleiterschalters (25) zu schließen, wenn das dem Leistungshalbleiterschalter (25) entsprechende Ausgangssignal sich entsprechend dem pulsweitenmodulierten Signal ändert.

6. Elektrische Vorrichtung nach Anspruch 5, bei der jeder der Strompfade (51-54) wenigstens einen Leistungshalbleiterschalter (25, 26) umfasst.

7. Elektrische Vorrichtung nach Anspruch 5, bei dem der erste Strompfad (51) und der zweite Strompfad (52) jeweils wenigstens einen Leistungshalbleiterschalter (25,26) und der dritte Strompfad (53) und der vierte Strompfad (54) eine Diode (27, 28) umfasst.

8. Elektrische Vorrichtung nach einem der Ansprüche 5 bis 7, bei dem jedem der Strompfade (51-54) jeweils mindestens ein Impulsübertrager (41-44) zugeordnet ist, welche jeweils eingerichtet sind, ein der Änderung des Betrags und/oder der Richtung des durch den entsprechenden Strompfad (51) fließenden elektrischen Stroms (i1) entsprechendes Ausgangssignal zu erzeugen, und die Steuervorrichtung (10) eingerichtet ist, auf die Funktionstüchtigkeit der jeweiligen Leistungshalbleiterschalter (25, 26) zu schließen, wenn wenn das dem Leistungshalbleiterschalter (25) entsprechende Ausgangssignal sich entsprechend dem pulsweitenmodulierten Signal ändert.

9. Elektrische Vorrichtung nach einem der Ansprüche 5 bis 7, bei der lediglich dem ersten und dem zweiten Strompfad (51, 52) wenigstens ein Impulsübertrager (41, 42), oder bei der lediglich dem dritten und dem vierten Strompfad (53, 54) wenigstens ein Impulsübertrager (43,44) zugeordnet ist.

10. Verfahren zum Testen des Netzteils (21) der elektrischen Vorrichtung (1) nach einem der Ansprüche 1 bis 9, aufweisend folgende Verfahrensschritte:
- Erzeugen eines pulsweitenmodulierten Signals,
- dem pulsweitenmodulierten Signal entsprechendes abwechselndes Öffnen und Schließen des wenigstens einen Leistungshalbleiterschalters (25, 26), um die elektrische Versorgungspannung oder den elektrischen Strom für den elektrischen Verbraucher (29) aus einer elektrischen Spannung zu erzeugen,
- Erzeugen eines Ausgangssignals, welches der Änderung des Betrags und/oder der Richtung des elektrischen Stroms (i1) durch den Pfad (51) des Leistungsteils (23) des Netzteils (21) entspricht, mittels des Impulsübertrages (51), und
- Schließen auf die Funktionstüchtigkeit des Leistungshalbleiterschalters (25, 26) aufgrund des ausgewerteten Signals, wenn das Ausgangssignal sich entsprechend dem pulsweitenmodulierten Signal ändert.

## Claims

1. Electrical device, in particular an electrical machine, comprising:
an electrical load (29),
a control device (10) generating a pulse width modulated signal,
a clocked power supply (21) which comprises a power section (23) with at least one power semiconductor switch (25, 26) and which is configured to generate an electrical supply voltage or an electrical current for the electrical load (29) from an electrical voltage, based on the alternating on and off switching corresponding to the pulse width modulated signal, of the at least one power semiconductor switch (25, 26), wherein the power section (23) comprises at least one current path (51-54) through which an electrical current flows (i1) at operation of the power supply (21),
at least one pulse transducer (41-44) which is configured to generate an output signal corresponding to the variation of the absolute value and/or direction of the electrical current (i1) flowing through the current path (51), and
an evaluation circuit (39) connected downstream to the pulse transducer, which is configured to transmit the output signal to the control device (10), and
the control device (10) is configured to infer on the functional reliability of the power semiconductor switch (25, 26), when the output signal changes according to the pulse width modulated signal.

2. Electrical device according to claim 1, wherein the power section (23) is formed as an inverter and/or wherein the at least one power semiconductor switch (25, 26) is formed as a power transistor, in particular a FET or a MOSFET, and/or wherein the electrical load is implemented as an electrical inductive load (29).

3. Electrical device according to claim 2, wherein the inductive load (29) is implemented as an electromechanical brake.

4. Electrical device according to any of claims 1 to 3, wherein the at least one power semiconductor switch (25, 26) is part of the current path (51, 52).

5. Electrical device according to any of claims 1 to 4, whose power section (23) is formed as an H-bridge, which particularly comprises: a first current path (51) through which a first electrical current (i1) flows at operation of the power supply (21), a second current path (52) through which a second electrical current flows at operation of the power supply (21), a third current path (53) through which a third electrical current flows at operation of the power supply (21), and a fourth current path (54) through which a fourth electrical current flows at operation of the power supply (21),
wherein the first current path (51) and the fourth current path (54) are connected with a common first node (K2) and the second current path (52) and the third current path (53) are connected with a common second node (K3), between which the electrical load (29) is connected,
wherein a pulse transducer (41-44) is assigned to at least the first, second, third and/or fourth current path (51-54), which is configured to generate an output signal corresponding to the variation of the absolute value and/or the direction of the electrical current (i1) flowing through the corresponding current path (51), and
the control device (10) is configured to infer on the functional reliability of the power semiconductor switch (25), when the output signal corresponding to the power semiconductor switch (25) changes according to the pulse width modulated signal.

6. Electrical device according to claim 5, wherein each of the current paths (51-54) comprises at least one power semiconductor switch (25, 26).

7. Electrical device according to claim 5, wherein the first current path (51) and the second current path (52) respectively comprises at least one power semiconductor switch (25, 26), and the third current path (53) and the fourth current path (54) comprises a diode (27, 28).

8. Electrical device according to any of claims 5 to 7, wherein at least one pulse transducer (41-44) is assigned to each of the current paths (51-54), which are respectively configured to generate an output signal corresponding to the variation of the absolute value and/or the direction of the electrical current (i1) flowing through the corresponding current path (51), and the control device (10) is configured to infer on the functional reliability of the respective power semiconductor switches (25, 26), when the output signal corresponding to the power semiconductor switch (25) changes according to the pulse width modulated signal.

9. Electrical device according to any of claims 5 to 7, wherein at least one pulse transducer (41, 42) is assigned to only the first and the second current path (51, 52), or wherein at least one pulse transducer (41, 42) is assigned to only the third and the fourth current path (53, 54).

10. Method for testing the power supply (21) of the electrical device (1) according to any of claims 1 to 9, comprising the following method steps:
- generating an pulse width modulated signal,
- alternating opening and closing, according to the pulse width modulated signal, of the at least one power semiconductor switch (25, 26) so as to generate the electrical supply voltage or the electrical current for the electrical load (29) from an electrical voltage,
- generating an output signal, which corresponds to the variation of the absolute value and/or the direction of the electrical current (i1) through the path (51) of the power section (23) of the power supply (21), by means of the pulse transducer (41), and
- inferring on the functional reliability of the power semiconductor switch (25, 26) based on the evaluated signals, when the output sognal changes according to the pulse width modulated signal.

## Revendications

1. Dispositif électrique, en particulier machine électrique, présentant
- un consommateur électrique (29),
- un dispositif de commande (10), lequel génère un signal modulé en largeur d'impulsion,
- une alimentation électrique pulsée (21), laquelle présente un élément de puissance (23) avec au moins un interrupteur à semi-conducteur de puissance (25, 26) et qui est aménagée pour générer une tension d'alimentation électrique ou un courant électrique pour le consommateur électrique (29) à partir d'une tension électrique en raison d'une mise en marche et arrêt alternée correspondant au signal modulé en largeur d'impulsion de l'au moins un interrupteur à semi-conducteur de puissance (25, 26), dans lequel l'élément de puissance (23) présente au moins un chemin de courant (51-54), par lequel un courant électrique (i1) circule lors du fonctionnement de l'alimentation électrique (21),
- au moins un transmetteur d'impulsion (41-44), lequel est aménagé pour générer un signal de sortie correspondant à la modification de la valeur et/ou de la direction du courant électrique (i1) circulant par le chemin de courant (51), et
- un circuit d'exploitation (39) en aval du transmetteur d'impulsion, lequel est aménagé pour transmettre le signal de sortie au dispositif de commande (10), et
- le dispositif de commande (10) est aménagé pour conclure au bon fonctionnement de l'interrupteur à semi-conducteur de puissance (25, 26), lorsque le signal de sortie change en fonction du signal modulé en largeur d'impulsion.

2. Dispositif électrique selon la revendication 1, dans lequel l'élément de puissance (23) est réalisé en tant qu'onduleur et/ou dans lequel l'au moins un interrupteur à semi-conducteur de puissance (25, 26) est réalisé en tant que transistor de puissance en particulier en tant que FET ou MOSFET, et/ou dans lequel le consommateur électrique est réalisé en tant que consommateur inductif électrique (29).

3. Dispositif électrique selon la revendication 2, dans lequel le consommateur inductif (29) est réalisé en tant que frein électromécanique.

4. Dispositif électrique selon l'une quelconque des revendications 1 à 3, dans lequel l'au moins un interrupteur à semi-conducteur de puissance (25, 26) fait partie du chemin de courant (51, 52).

5. Dispositif électrique selon l'une quelconque des revendications 1 à 4, dont l'élément de puissance (23) est réalisé en tant que pont en H, lequel présente en particulier un premier chemin de courant (51), par lequel circule un premier courant électrique (i1) lors du fonctionnement de l'alimentation électrique (21), un deuxième chemin de courant (52), par lequel circule un deuxième courant électrique lors du fonctionnement de l'alimentation électrique (21), un troisième chemin de courant (53), par lequel circule un troisième courant électrique lors du fonctionnement de l'alimentation électrique (21), et un quatrième chemin de courant (54), par lequel circule un quatrième courant électrique lors du fonctionnement de l'alimentation électrique (21), dans lequel le premier chemin de courant (51) et le quatrième chemin de courant (54) sont reliés à un premier noeud commun (K2) et le deuxième chemin de courant (52) et le troisième chemin de courant (53) sont reliés à un deuxième noeud commun (K3), entre lesquels le consommateur électrique (29) est branché, dans lequel un transmetteur d'impulsion (41-44) est associé au moins au premier, deuxième, troisième et/ou quatrième chemin de courant (51-54), lequel est aménagé pour générer un signal de sortie correspondant à la modification de la valeur et/ou de la direction du courant électrique (i1) circulant par le chemin de courant (51) correspondant, et le dispositif de commande (10) est aménagé pour conclure au bon fonctionnement de l'interrupteur à semi-conducteur de puissance (25), lorsque le signal de sortie correspondant à l'interrupteur à semi-conducteur de puissance (25) change en fonction du signal modulé en largeur d'impulsion.

6. Dispositif électrique selon la revendication 5, dans lequel chacun des chemins de courant (51-54) comprend au moins un interrupteur à semi-conducteur de puissance (25, 26).

7. Dispositif électrique selon la revendication 5, dans lequel le premier chemin de courant (51) et le deuxième chemin de courant (52) comprennent respectivement au moins un interrupteur à semi-conducteur de puissance (25, 26) et le troisième chemin de courant (53) et le quatrième chemin de courant (54) comprennent une diode (27, 28).

8. Dispositif électrique selon l'une quelconque des revendications 5 à 7, dans lequel respectivement au moins un transmetteur d'impulsion (41-44) est associé à chacun des chemins de courant (51-54), lesquels sont respectivement aménagés pour générer un courant de sortie correspondant à la modification de la valeur et/ou de la direction du courant électrique (i1) circulant par le chemin de courant (51) correspondant, et le dispositif de commande (10) est aménagé pour conclure au bon fonctionnement des interrupteurs à semi-conducteur de puissance (25, 26) respectifs, lorsque le signal de sortie correspondant à l'interrupteur à semi-conducteur de puissance (25) change en fonction du signal modulé en largeur d'impulsion.

9. Dispositif électrique selon l'une quelconque des revendications 5 à 7, dans lequel au moins un transmetteur d'impulsion (41, 42) est simplement associé au premier et au deuxième chemin de courant (51, 52), ou dans lequel au moins un transmetteur d'impulsion (43, 44) est simplement associé au troisième et au quatrième chemin de courant (53, 54).

10. Procédé de test de l'alimentation électrique (21) du dispositif électrique (1) selon l'une quelconque des revendications 1 à 9, présentant les étapes suivantes :
- génération d'un signal modulé en largeur d'impulsion,
- ouverture et fermeture alternée correspondant au signal modulé en largeur d'impulsion de l'au moins un interrupteur à semi-conducteur de puissance (25, 26) pour générer la tension d'alimentation électrique ou le courant électrique pour le consommateur électrique (29) à partir d'une tension électrique,
- génération d'un signal de sortie, lequel correspond à la modification de la valeur et/ou de la direction du courant électrique (i1) par le chemin (51) de l'élément de puissance (23) de l'alimentation électrique (21), au moyen du transmetteur d'impulsion (51), et
- conclusion au bon fonctionnement de l'interrupteur à semi-conducteur de puissance (25, 26) en raison du signal exploité, lorsque le signal de sortie change en fonction du signal modulé en largeur d'impulsion.
